# EUROPEAN PATENT APPLICATION

(11) **EP 4 475 361 A1**
(43) Date of publication of application: **11.12.2024**
(21) Application number: 22924985.9
(22) Date of filing: 09.12.2022
(51) Int. Cl.: H01S 5/028

(54) **SEMICONDUCTOR LASER ELEMENT**

(30) Priority: 01.02.2022 JP 2022014354
(71) Applicant: Panasonic Holdings Corporation, Osaka, 571-8501 (JP)
(72) Inventor: MOCHIDA, Atsunori, Kadoma-shi, Osaka 571-0057 (JP)
(74) Representative: Novagraaf International SA
(86) International application number: PCT/JP2022/045514
(87) International publication number: WO 2023/149081

(57) **Abstract**

This semiconductor laser element includes: a semiconductor stack body that emits a laser beam; an emission-side protective layer disposed on an emission end face of the semiconductor stack body, the emission end face being an end face from which the laser beam is emitted; and a non-emission-side protective layer that is disposed on an end face of the semiconductor stack body on a side opposite to the emission end face and that reflects the laser beam, wherein the emission-side protective layer includes a control layer that suppresses a reflectivity on an emission side with respect to a wavelength of the laser beam to be less than or equal to a predetermined value, and the control layer includes a strain relaxation layer that suppresses strain associated with thermal expansion of the control layer.

## Description

### TECHNICAL FIELD

The present disclosure relates to a semiconductor laser element.

### BACKGROUND ART

Conventionally, a laser processing technique using a laser device has been put into practical use. In order to expand the application of the laser processing technique, a laser beam is required to have higher output power and higher quality. Generally, it is necessary to narrow a laser beam in order to improve the quality of the laser beam.

As an example of the laser device, there is an external cavity laser device including an external resonator that forms a resonance state of a laser beam by an optical component such as a diffraction grating disposed apart from a semiconductor laser element. In the external cavity laser device, a beam-combining optical system that combines a plurality of laser beams emitted from the semiconductor laser element is constructed in the external resonator, so that laser beams with high output power and high quality can be emitted.

As a method for combining a plurality of laser beams, there are spatial beam combining and wavelength beam combining. The spatial beam combining is a method for spatially combining a plurality of laser beams without converging the laser beams on the same optical axis. On the other hand, the wavelength beam combining is a method for converging a plurality of laser beams having different wavelengths on the same optical axis. In order to achieve a narrow beam by combining a plurality of laser beams, the wavelength beam combining is more preferable than the spatial beam combining in which a plurality of optical axes are different from each other.

When the wavelength beam combining is applied, a semiconductor laser element (so-called laser array element) having a plurality of light emission points, for example, is adopted as the semiconductor laser element.

Meanwhile, in the external cavity laser device, it is necessary to reduce the reflectivity of the laser array element on a laser-beam emission-side end face as much as possible in order to suppress internal resonance in the laser array element. The reflectivity on the emissions-side end face side is required to be, for example, less than or equal to 1%.

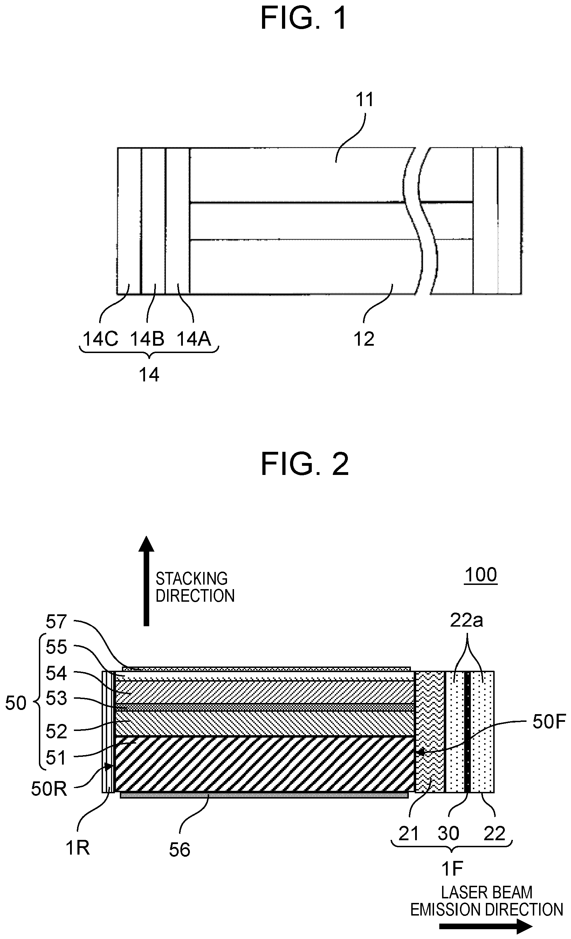

For example, Patent Literature 1 discloses providing an emission-side protective layer including a plurality of dielectric layers on a laser-beam emission-side end face of a multi-wavelength semiconductor laser element, by which the reflectivity on the emission-side end face is reduced. Fig. 1 is a schematic diagram illustrating a planar configuration of the multi-wavelength semiconductor laser element disclosed in Patent Literature 1.

The multi-wavelength semiconductor laser element disclosed in Patent Literature 1 includes a first light emitter 11 that emits a laser beam in a 650 nm band and a second light emitter 12 that emits a laser beam in a 780 nm band. In addition, the multi-wavelength semiconductor laser element has an emission-side protective layer 14 including a plurality of dielectric layers 14A, 14B, and 14C on a laser-beam emission-side end face. The emission-side protective layer 14 reduces the reflectivity on the emission-side end face with respect to the laser beam in a wavelength range including the 650 nm band and the 780 nm band.

### Citation List

### Patent Literature

PTL 1: Unexamined Japanese Patent Publication No. 2010-219436

### SUMMARY OF THE INVENTION

A semiconductor laser element according to one aspect of the present disclosure includes:
a semiconductor stack body that emits a laser beam;
an emission-side protective layer disposed on an emission end face of the semiconductor stack body, the emission end face being an end face from which the laser beam is emitted; and
a non-emission-side protective layer that is disposed on an end face of the semiconductor stack body on a side opposite to the emission end face and that reflects the laser beam,
wherein the emission-side protective layer includes a control layer that suppresses a reflectivity on an emission side with respect to a wavelength of the laser beam to be less than or equal to a predetermined value, and
the control layer includes a strain relaxation layer that suppresses strain associated with thermal expansion of the control layer.

### BRIEF DESCRIPTION OF THE DRAWINGS

Fig. 1 is a schematic diagram illustrating a planar configuration of a multi-wavelength semiconductor laser element disclosed in Patent Literature 1.
Fig. 2 is a schematic cross-sectional view illustrating a configuration of a semiconductor laser element according to a first exemplary embodiment.
Fig. 3 is a schematic diagram illustrating a semiconductor laser device including the semiconductor laser element according to the first exemplary embodiment.
Fig. 4 is a schematic cross-sectional view illustrating a configuration of a semiconductor laser element according to a second exemplary embodiment.
Fig. 5 is a graph showing reflectivity of the semiconductor laser element on a side of a laser-beam emission-side end face, and shows reflectivity-wavelength characteristics for each type of protective layer on an emission end face side.

### DESCRIPTION OF EMBODIMENT

The structure of an emission-side protective layer of a semiconductor laser element is appropriately adjusted, for example, by the type of layers constituting the emission-side protective layer or an increase in thickness of the emission-side protective layer in order to ensure the reliability of laser beams. In addition, in order to achieve desired laser characteristics, the structure of the emission-side protective layer is appropriately adjusted so that the reflectivity on the side of the entire emission-side end face including reflection inside the emission-side protective layer is suppressed.

Meanwhile, when the emission-side protective layer includes a layer having a high thermal expansion coefficient, an internal stress may be generated due to thermal expansion of the emission-side protective layer, and thus, the emission-side protective layer may be separated or a laser-beam emission-side end face of the multi-wavelength semiconductor laser element may be deteriorated, leading to deterioration of laser quality. In addition, as the thickness of the emission-side protective layer increases, the laser quality tends to deteriorate due to internal stress.

An object of the present disclosure is to provide a semiconductor laser element capable of reducing reflectivity on the side of a laser-beam emission-side end face and improving laser quality.

Exemplary embodiments and modifications according to the present disclosure will be described below with reference to the drawings. Note that the exemplary embodiments and modifications described below each illustrate one specific example of the present disclosure. Therefore, numerical values, shapes, materials, components, placement positions and connection forms of the components, and the like shown in the following exemplary embodiments and modifications are merely examples, and are not intended to limit the present disclosure. In addition, the drawings are schematically illustrated and thus are not strictly accurate. Therefore, scales and the like are not necessarily matched in the respective drawings. Note that, in each drawing, substantially the same components are denoted by the same reference marks, and redundant description will be omitted or simplified. Furthermore, in the present description, the terms "upper" and "lower" do not refer to an upward direction (vertically upward) and a downward direction (vertically downward) in absolute space recognition, but are used as terms defined by a relative positional relationship based on a stacking order in a stacking configuration of a semiconductor stack body described later. In addition, the terms "above" and "below" are not only applied to a case where two components are spaced apart from each other and another component is present between the two components, but are also applied to a case where two components are disposed in close contact with each other.

### (First exemplary embodiment)

Semiconductor laser element 100 according to the first exemplary embodiment will now be described herein with reference to Fig. 2. Fig. 2 is a schematic cross-sectional view illustrating semiconductor laser element 100 according to the first exemplary embodiment. Fig. 2 illustrates a cross section of semiconductor laser element 100 in a plane along a stacking direction of layers of semiconductor stack body 50 (described later) and an emission direction of a laser beam.

### [1-1. Overall configuration]

Semiconductor laser element 100 is a semiconductor light emitting element that emits a plurality of laser beams, that is, a so-called semiconductor laser array. In the present exemplary embodiment, semiconductor laser element 100 is a gallium nitride semiconductor laser element, and emits a laser beam having a wavelength in a band ranging from about 390 nm to 530 nm inclusive.

Semiconductor laser element 100 includes semiconductor stack body 50, emission-side protective layer 1F, and non-emission-side protective layer 1R.

### [1-1-1. Semiconductor stack body]

Semiconductor stack body 50 is a stack of a plurality of semiconductor layers.

Semiconductor stack body 50 includes substrate 51, first semiconductor layer 52, active layer 53, second semiconductor layer 54, and contact layer 55.

Substrate 51 is a plate-shaped member serving as a base material of semiconductor stack body 50. In the present exemplary embodiment, substrate 51 is a GaN single crystal substrate. The thickness of substrate 51 is, for example, about 100 µm. The material for forming substrate 51 may be a single crystal of Al₂O₃ (sapphire), SiC, GaAs, InP, or the like. The thickness of substrate 51 may be, for example, from 50 µm to 120 µm inclusive.

First semiconductor layer 52 is a semiconductor layer disposed above substrate 51. In the present exemplary embodiment, first semiconductor layer 52 is an n-type semiconductor layer and includes an n-type cladding layer.

The n-type cladding layer is a layer including n-Al_{0.2}Ga_{0.8}N. The thickness of the n-type cladding layer is, for example, about 1 µm. It is only sufficient that the n-type cladding layer includes, for example, n-AlₓGa₁₋ₓN (0 < x < 1). In addition, the thickness of the n-type cladding layer may be, for example, from 0.5 µm to 5 µm inclusive.

In addition, an n-type AlₓInyGa_{1-x-y}N (0 ≤ x + y ≤ 1) guide layer or an undoped AlₓInyGa1_{-x-y}N (0 ≤ x + y ≤ 1) guide layer may be formed on the n-type cladding layer.

Active layer 53 is a layer disposed above first semiconductor layer 52. Active layer 53 functions as a light emission layer. In the present exemplary embodiment, active layer 53 has two well layers. Specifically, active layer 53 is a quantum well active layer obtained by alternately stacking a well layer including In_{0.18}Ga_{0.82}N and a barrier layer including GaN. Here, the thickness of the well layer is, for example, about 5 nm, and the thickness of the barrier layer is, for example, about 10 nm. By having such active layer 53, semiconductor laser element 100 can emit, for example, a blue laser beam having a wavelength of about 450 nm.

It is only sufficient that active layer 53 is a quantum well active layer obtained by alternately stacking a well layer including InₓGa₁₋ₓN (0 < x < 1) and a barrier layer including AlₓIn_{y}Ga_{1-x-y}N (0 ≤ x + y ≤ 1).

Note that active layer 53 may include a guide layer at least above and/or below the quantum well active layer. In the present exemplary embodiment, the number of the well layers is two, but may be from one to four inclusive. In addition, the In composition of the well layer may be appropriately selected such that a beam having a desired wavelength within a wavelength range from 390 nm to 530 nm inclusive is emitted.

Second semiconductor layer 54 is a semiconductor layer formed above active layer 53. In the present exemplary embodiment, second semiconductor layer 54 is a p-type semiconductor layer and includes a p-type cladding layer. The p-type cladding layer is a superlattice layer obtained by alternately stacking 100 layers each including p-Al_{0.2}Ga_{0.8}N and 100 layers each including GaN. The thickness of the p-Al_{0.2}Ga_{0.8}N layer is, for example, about 3 nm, and the thickness of the GaN layer is, for example, about 3 nm.

The p-type cladding layer may not be the above-described superlattice layer but may be a layer including AlₓGa₁₋ₓN (0 < x < 1). The thickness of this layer may be, for example, from 0.3 µm to 1 µm inclusive. Alternatively, the p-type cladding layer may be a bulk cladding layer including AlₓGa₁₋ₓN (0 < x < 1).

In the present exemplary embodiment, AlGaN is used as a material of the p-type cladding layer. This is because AlGaN has a refractive index suitable for confining a laser beam in active layer 53. A material other than AlGaN may be used as the material of the p-type cladding layer. For example, ITO may be used as a material of the p-type cladding layer. As the material of the p-type cladding layer, a material that transmits a laser beam to be emitted, for example, a transparent dielectric oxide such as In₂O₃, Ga₂O₃, SnO, or InGaOs may be used.

In addition, second semiconductor layer 54 may have a plurality of p-type AlₓIn_{y}Ga_{1-x-y}N (0 ≤ x + y ≤ 1) guide layers or a plurality of undoped AlₓIn_{y}Ga_{1-x-y}N (0 ≤ x + y ≤ 1) guide layers below the p-type cladding layer.

Contact layer 55 is a semiconductor layer formed above second semiconductor layer 54 and is in ohmic contact with second electrode 57. In the present exemplary embodiment, contact layer 55 is a p-type semiconductor layer and includes p-GaN. The thickness of contact layer 55 is, for example, about 10 nm.

Note that the material of contact layer 55 is not limited to p-GaN. In addition, the thickness of contact layer 55 may be, for example, from 5 nm to 200 nm inclusive.

In the present exemplary embodiment, two or more ridge portions are formed in second semiconductor layer 54 and contact layer 55. A region of active layer 53 corresponding to each ridge portion (i.e., a region of active layer 53 located below each ridge portion) serves as a light emission point, and laser beams are emitted from a plurality of light emission points.

A lower principal surface of substrate 51 (i.e., a principal surface on which first semiconductor layer 52 and the like are not disposed) is provided with first electrode 56 as an electrode.

In the present exemplary embodiment, first electrode 56 is an n-side electrode, and has a stack structure in which a Ti layer, a Pt layer, and an Au layer are stacked in this order from a substrate 51 side. Note that first electrode 56 may have another stack structure, for example, a stack structure in which a Ti layer and an Au layer are stacked.

Second electrode 57 is disposed on contact layer 55 as an electrode. In the present exemplary embodiment, second electrode 57 includes a p-side electrode in ohmic contact with contact layer 55, and a pad electrode disposed on the p-side electrode.

The p-side electrode has a stack structure in which a Pd layer and a Pt layer are sequentially stacked from the contact layer 55 side. The configuration of the p-side electrode is not limited thereto. The p-side electrode may have, for example, a single layer structure or a multilayer structure including at least one of a Cr layer, a Ti layer, a Ni layer, a Pd layer, a Pt layer, and an Au layer.

The p-side electrode may be an ITO layer used as a transparent oxide electrode, or may be an In₂O₃ layer, a Ga₂O₃ layer, a SnO layer, or an InGaO₃ layer.

The pad electrode is a pad-shaped electrode disposed above the p-side electrode. In the present exemplary embodiment, the pad electrode has a stack structure in which a Ti layer and an Au layer are sequentially stacked from the p-side electrode side, the pad electrode being disposed in and around the ridge portions.

The pad electrode may include, for example, only an Au layer, or may have a stack structure in which a Ti layer, a Pt layer, and an Au layer are stacked, or a stack structure in which a Ni layer and an Au layer are stacked. The pad electrode may have a stack structure in which two or more layers including other metals are stacked.

Although not illustrated in Fig. 2, semiconductor stack body 50 may further include an insulating layer such as a SiO₂ film that covers a side wall of the ridge portion, and the like.

### [1-1-2. Non-emission-side protective layer 1R]

Non-emission-side protective layer 1R is a layer disposed on laser-beam non-emission-side end face 50R (hereinafter referred to as "non-emission-side end face 50R") of semiconductor stack body 50. Non-emission-side protective layer 1R protects non-emission-side end face 50R, and increases the reflectivity of semiconductor stack body 50 on the non-emission side with respect to a laser beam to a certain value (for example, 90%) or more. The "reflectivity on the non-emission side" means a reflectivity comprehensively evaluated by combining non-emission-side end face 50R and non-emission-side protective layer 1R.

In the present exemplary embodiment, non-emission-side protective layer 1R has a multilayer structure obtained by stacking a plurality of sets of SiO₂ layers and AlO₁₋ₓNₓ (0 < x < 1) layers. The thickness of each of the SiO₂ layer and the AlO₁₋ₓNₓ (0 < x < 1) layer is, for example, about λa/(4n) when the average wavelength of a plurality of laser beams is λa and the refractive indexes of the SiO₂ layer and the AlO₁₋ₓNₓ (0 < x < 1) layer are n.

Due to the non-emission-side protective layer 1R having such a structure, the reflectivity on the non-emission side with respect to the laser beam is greater than or equal to 90%. As a result, semiconductor laser element 100 having high slope efficiency and low threshold current can be achieved.

Note that the stack structure of non-emission-side protective layer 1R is not limited as long as a desired value of the reflectivity on the non-emission side can be obtained. For example, non-emission-side protective layer 1R may have a stack structure obtained by stacking a plurality of sets of a SiO₂ layer and a ZrO₂ layer, a plurality of sets of a SiO₂ layer and a Ta₂O₅ layer, a plurality of sets of a SiO₂ layer and an AlN layer, a plurality of sets of a SiO₂ layer and a TiO₂ layer, a plurality of sets of a SiO₂ layer and a HfO₂ layer, a plurality of sets of a SiO₂ layer and a Nb₂O₅ layer, a plurality of sets of a SiO₂ layer and an Al₂O₃ layer, or the like. In addition, an Al₂O₃ layer may be used as a layer having a low refractive index among the above-described sets of layers excluding the set of the SiO₂ layer and the Al₂O₃ layer.

Non-emission-side protective layer 1R may have a single layer structure or a multilayer structure including at least one of an oxynitride layer and a nitride layer.

### [1-1-3. Emission-side protective layer 1F]

Emission-side protective layer 1F is a layer disposed on laser-beam emission-side end face 50F (hereinafter referred to as "emission-side end face 50F") of semiconductor stack body 50. Emission-side protective layer 1F protects emission-side end face 50F and reduces the reflectivity of semiconductor stack body 50 on the emission side with respect to the laser beam. The "reflectivity on the emission side" means a reflectivity comprehensively evaluated by combining emission-side end face 50F and emission-side protective layer 1F.

Emission-side protective layer 1F includes barrier layer 21 and control layer 22. Note that, in the following description, the reflectivity on the emission side may be simply referred to as "reflectivity".

### <Barrier layer>

Barrier layer 21 is disposed in contact with emission-side end face 50F. Barrier layer 21 has a function of suppressing deterioration of emission-side end face 50F of semiconductor stack body 50. Barrier layer 21 is a dielectric layer, and is specifically an oxynitride layer or a nitride layer.

In the present exemplary embodiment, barrier layer 21 is, for example, a single layer including AlO₁₋ₓNₓ (0 < x < 1). The thickness of barrier layer 21 is, for example, about 20 nm. Note that barrier layer 21 may be, for example, an oxynitride layer such as a SiO₁₋ₓNₓ (0 < x < 1) layer, or a nitride layer such as an AlN layer or a SiN layer.

### <Control layer>

Control layer 22 is disposed in contact with the emission-side surface of barrier layer 21. Control layer 22 has a function of adjusting the reflectivity of semiconductor stack body 50 on the emission side. More specifically, control layer 22 suppresses the reflectivity on the emission side to be less than or equal to a predetermined value (for example, 1%) with respect to the oscillation wavelength of each laser beam.

Control layer 22 includes main control layer 22a that contributes to adjustment of reflectivity and strain relaxation layer 30 that relaxes strain of entire control layer 22. Main control layer 22a and strain relaxation layer 30 are different in material.

Main control layer 22a is a dielectric layer, and is specifically an oxynitride layer, a nitride layer, or an oxide layer. In the present exemplary embodiment, main control layer 22a includes, for example, Al₂O₃. The total thickness of main control layers 22a on both sides of strain relaxation layer 30 is, for example, about 55 nm.

Main control layer 22a may be an oxynitride layer such as an AlO₁₋ₓNₓ (0 < x < 1) layer or a SiO₁₋ₓNₓ (0 < x < 1) layer, a nitride layer such as an AlN layer or an SiN layer, or an oxide layer such as a TiO₂ layer, a Nb₂O₅ layer, a ZrO₂ layer, a Ta₂O₅ layer, or a HfO₂ layer. Due to such a structure, main control layer 22a can suppress the reflectivity on the emission side to be less than or equal to 1% with respect to the wavelength of each laser beam. As a result, stable external resonance characteristics can be achieved in the laser device including semiconductor laser element 100.

Strain relaxation layer 30 is disposed so as to be located at an intermediate position of control layer 22 in the traveling direction of laser beams. That is, strain relaxation layer 30 is sandwiched between two main control layers 22a. Two main control layers 22a may include the same material or different materials.

Strain relaxation layer 30 has a function of suppressing strain associated with thermal expansion of entire emission-side protective layer 1F including control layer 22. The thermal expansion of control layer 22 is caused by heat generation due to the emission of laser beams.

Strain relaxation layer 30 is a dielectric layer and has a thermal expansion coefficient smaller than that of at least main control layer 22a. Preferably, strain relaxation layer 30 includes a material having the smallest thermal expansion coefficient among the layers included in emission-side protective layer 1F. For strain relaxation layer 30, a material having small light absorption in a wavelength range around a 450 nm band is selected in order to suppress absorption of laser beam.

In the present exemplary embodiment, strain relaxation layer 30 includes SiO₂. SiO₂ is a material having a relatively small thermal expansion coefficient and small light absorption around the 450 nm band. Further, SiO₂ is an oxide layer, and thus is less susceptible to peripheral layers and outside air.

### <Effect of strain relaxation layer>

When laser beams are emitted from semiconductor laser element 100, the vicinity of emission-side end face 50F has a high temperature, so that emission-side protective layer 1F is thermally expanded. At this time, tensile stress is generated at the interface between semiconductor stack body 50 and emission-side protective layer 1F. In particular, when a part of emission-side protective layer 1F includes a layer including a material having a large thermal expansion coefficient, the tensile stress increases.

This tensile stress causes deterioration such as formation of dislocations in the vicinity of active layer 53 on emission-side end face 50F. As a result, the output value and the quality of laser beams are deteriorated. In addition, the tensile stress causes separation of emission-side protective layer 1F.

Control layer 22 includes strain relaxation layer 30 including a material having a small thermal expansion coefficient, and thus, it is possible to suppress strain associated with thermal expansion of entire emission-side protective layer 1F including control layer 22. More specifically, the thermal expansion of emission-side protective layer 1F can be suppressed, and the tensile stress generated at the interface between emission-side protective layer 1F and emission-side end face 50F can be reduced.

Therefore, deterioration of emission-side protective layer 1F can be suppressed, and the output value and quality of laser beams can be improved. As shown in Table 1 below, SiO₂ forming strain relaxation layer 30 has a thermal expansion coefficient smaller than that of Al₂O₃ or the like forming main control layer 22a. Therefore, providing strain relaxation layer 30 between two main control layers 22a (Al₂O₃ layers) can effectively suppress the strain associated with the thermal expansion of emission-side protective layer 1F.

**[Table 1]**

| | Thermal expansion coefficient (1/K) |
|---|---|
| GaN | 5.6 |
| AIN | 4.5 |
| AI₂O₃ | 7.0 |
| SiN | 3.0 |
| SiO₂ | 0.5 |
| ZrO₂ | 7.7 |
| TiO₂ | 7.8 |
| HfO₂ | 3.8 |

Note that the material of strain relaxation layer 30 is only required to have a thermal expansion coefficient smaller than that of the material of main control layers 22a. It is more desirable that strain relaxation layer 30 includes a material having the smallest thermal expansion coefficient among the layers included in emission-side protective layer 1F.

In addition, a material other than SiO₂ may be used as long as it has smaller light absorption (for example, it has an extinction coefficient less than or equal to 2.0 × 10⁻³) with respect to the oscillation wavelength of each laser beam.

In order to improve the quality of laser beams while maintaining the reflectivity less than or equal to 1% with respect to the oscillation wavelength of each laser beam, strain relaxation layer 30 may not necessarily be the SiO₂ layer. Strain relaxation layer 30 may be another dielectric layer having a smaller thermal expansion coefficient, for example, a nitride layer such as an AlN layer or a SiN layer, an oxynitride layer such as an AlO₁₋ₓNₓ (0 < x < 1) layer or a SiO₁₋ₓNₓ (0 < x < 1) layer, or an oxide layer such as an Al₂O₃ layer, a Ta₂O₅ layer, or a HfO₂ layer.

As described above, the total thickness of main control layers 22a is, for example, about 55 nm. On the other hand, the thickness of strain relaxation layer 30 may be less than or equal to 2 nm, and is 1 nm in the present exemplary embodiment.

By reducing the thickness of strain relaxation layer 30, semiconductor laser element 100 has wavelength characteristics with respect to laser beams equivalent to those of a semiconductor laser element that does not have strain relaxation layer 30 and that has an emission-side protective layer having the same structure except for not having strain relaxation layer 30. This will be described later in detail.

Therefore, it is possible to suppress strain of emission-side protective layer 1F associated with thermal expansion while maintaining reflectivity-wavelength characteristics. Further, main control layer 22a is configured to suppress the reflectivity on the emission side to be less than or equal to 1.0% with respect to the oscillation wavelength of each laser beam when the emission-side protective layer without strain relaxation layer 30 is disposed on emission-side end face 50F, by which the reflectivity on the emission side can be maintained to be less than or equal to 1.0% even if strain relaxation layer 30 is added to emission-side protective layer 1F.

In the present exemplary embodiment, main control layer 22a is configured to suppress the reflectivity on the emission side to be less than or equal to 1.0% with respect to the oscillation wavelength of each laser beam when the emission-side protective layer without strain relaxation layer 30 is disposed on emission-side end face 50F. Therefore, the reflectivity on the emission side can be maintained to be less than or equal to 1.0%, although semiconductor laser element 100 according to the present exemplary embodiment has strain relaxation layer 30. As a result, stable external resonance characteristics can be achieved in the laser device including semiconductor laser element 100.

### <Position of strain relaxation layer>

Strain relaxation layer 30 may be present at any position of control layer 22. That is, the reflectivity on the emission side is suppressed to be less than or equal to 1% with respect to the oscillation wavelength of each laser beam wherever strain relaxation layer 30 is located in control layer 22, as long as main control layer 22a is configured to suppress the reflectivity on the emission side to be less than or equal to 1% with respect to the oscillation wavelength of each laser beam when the emission-side protective layer without strain relaxation layer 30 is disposed on the emission-side end face.

### [1-2. Manufacturing method]

Next, a method for manufacturing semiconductor laser element 200 according to the present exemplary embodiment will be described.

First, a semiconductor wafer to be a base of semiconductor stack body 50 is formed. When the semiconductor wafer is formed, substrate 51 is first prepared. Then, first semiconductor layer 52 that is an n-type cladding layer, active layer 53, second semiconductor layer 54 that is a p-type cladding layer, and contact layer 55 are sequentially stacked on substrate 51. Each layer can be formed by, for example, a metal organic chemical vapor deposition (MOCVD) method.

Subsequently, the ridge portion is formed in second semiconductor layer 54 and contact layer 55. The ridge portion can be formed, for example, by inductive coupled plasma (ICP) type reactive ion etching or the like.

The semiconductor wafer is formed through the above-described processes.

Subsequently, an insulating layer such as a SiO₂ layer is formed on the entire surface by, for example, a plasma CVD method or the like. Then, at least a part of the upper surface of the ridge portion of the insulating layer is removed by wet etching or the like to form an insulating layer on a side wall of the ridge portion or the like.

Next, second electrode 57 and first electrode 56 are formed on the region from which the insulating layer on the ridge portion is removed and the lower surface of substrate 51 by a vacuum vapor deposition method or the like.

Subsequently, primary cleavage of the semiconductor wafer is performed using, for example, a laser scribing machine and a breaking machine. As a result, semiconductor stack body 50 having emission-side end face 50F and non-emission-side end face 50R is formed as a laser bar.

Next, emission-side protective layer 1F and non-emission-side protective layer 1R are formed on emission-side end face 50F and non-emission-side end face 50R of semiconductor stack body 50, respectively. The dielectric layer is formed using, for example, a solid-source electron cyclotron resonance (ECR) sputtering plasma deposition apparatus. The use of this apparatus can suppress damage to emission-side end face 50F and the already formed layer, when each layer on emission-side end face 50F is formed.

Emission-side end face 50F and non-emission-side end face 50R may be formed using a vapor deposition apparatus, or the like, or may be formed using: an ablation deposition apparatus using pulse laser deposition (PLD), atomic layer deposition (ALD), or the like; an epitaxial growth apparatus using MOCVD or the like; or the like.

Semiconductor laser element 100 according to the present exemplary embodiment is manufactured through the above processes.

### [1-3. Application examples]

Next, an application example of semiconductor laser element 100 according to the present exemplary embodiment will be described.

### <Overall configuration of semiconductor laser device>

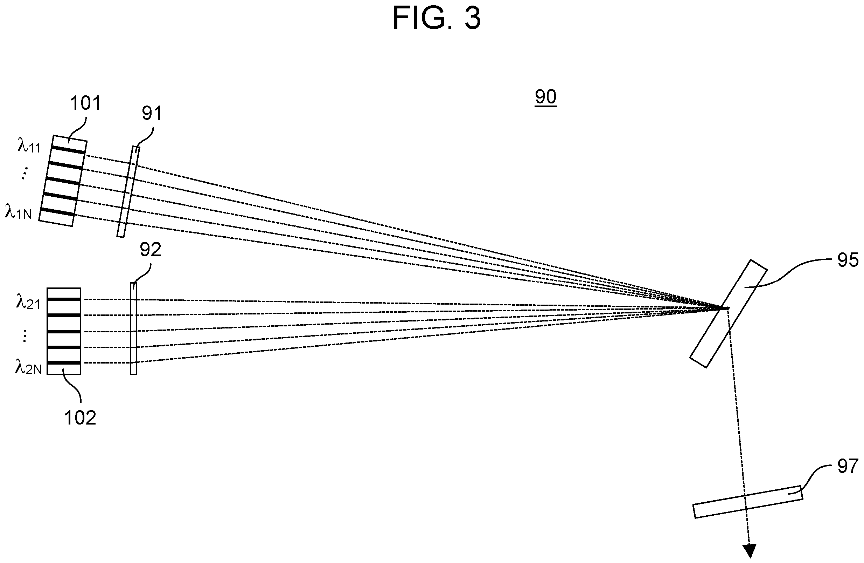

Fig. 3 is a schematic diagram illustrating semiconductor laser device 90 including the semiconductor laser element according to the first exemplary embodiment. Semiconductor laser device 90 is an external cavity semiconductor laser device that performs wavelength beam combining.

Semiconductor laser device 90 includes semiconductor laser elements 101 and 102, optical lenses 91 and 92, diffraction grating 95, and partially reflective mirror 97.

Semiconductor laser elements 101 and 102 have the same structure and the same function as those of semiconductor laser element 100 according to the first exemplary embodiment.

That is, semiconductor laser elements 101 and 102 are laser array elements having a plurality of light emission points. In other words, semiconductor laser elements 101 and 102 are used as small laser light sources that emit a plurality of laser beams. Therefore, semiconductor laser device 90 can be, for example, a small semiconductor laser device on which semiconductor laser elements 101 and 102 are mounted.

Semiconductor laser elements 101 and 102 have N (N is an integer more than or equal to 2) light emission points E11 to E1N and N light emission points E21 to E2N, respectively. A plurality of laser beams is emitted from light emission points E11 to E1N. A plurality of laser beams is emitted from light emission points E21 to E2N. The wavelength of the laser beam emitted from each light emission point is determined by a wavelength selection action by an external resonator including diffraction grating 95. Therefore, a plurality of laser beams having different wavelengths λ11 to λ1N are emitted as external resonance laser beams from light emission points E11 to E1N, and a plurality of laser beams having different wavelengths λ21 to λ2N are emitted as external resonance laser beams from light emission points E21 to E2N.

Semiconductor laser elements 101 and 102 are disposed to allow a plurality of laser beams to propagate in the same plane.

Optical lenses 91 and 92 are optical elements that respectively converge the laser beams emitted from semiconductor laser elements 101 and 102 onto diffraction grating 95. Note that each of optical lenses 91 and 92 may have a function of collimating laser beams. In addition, semiconductor laser device 90 may include a collimating lens that collimates each laser beam, separately from optical lenses 91 and 92.

Diffraction grating 95 is a wavelength dispersion element that multiplexes a plurality of laser beams having different wavelengths from each other, and specifically a transmissive diffraction grating. By appropriately setting the wavelengths and incident angles of a plurality of laser beams to be incident on diffraction grating 95 and intervals between slits of diffraction grating 95, the plurality of laser beams in different propagation directions can be combined on substantially the same optical axis.

Note that diffraction grating 95 may be an element other than the transmissive diffraction grating, for example, a prism or a reflective diffraction grating.

Partially reflective mirror 97 forms an external resonator with non-emission-side end faces of semiconductor laser elements 101 and 102. Partially reflective mirror 97 functions as an output coupler that transmits (that is, emits) a part of the laser beams. The reflectivity and transmittance of partially reflective mirror 97 may be appropriately set according to the gain or the like of semiconductor laser elements 101 and 102.

### <Operation of semiconductor laser device>

The operation of semiconductor laser device 90 will be described below.

When a current is supplied, each of semiconductor laser elements 101 and 102 emits N laser beams.

The N laser beams emitted from semiconductor laser element 101 are converged on a convergence point on diffraction grating 95 by optical lens 91. In addition, the N laser beams emitted from semiconductor laser element 102 are converged on the convergence point on diffraction grating 95 by optical lens 92. Note that the laser beams from semiconductor laser element 101 and the laser beams from semiconductor laser element 102 are converged at the same convergence point.

The 2N laser beams are diffracted by diffraction grating 95, propagate on substantially the same optical axis, and travels toward partially reflective mirror 97. Then, a portion of the laser beams entering partially reflective mirror 97 is reflected by partially reflective mirror 97, returns to semiconductor laser element 101 or 102 via diffraction grating 95 and optical lens 91 or 92, and is reflected by non-emission-side end face 50R of semiconductor laser element 101 or 102. As described above, the external resonator is formed between non-emission-side end face 50R of each of semiconductor laser elements 101 and 102 and partially reflective mirror 97.

In other words, semiconductor laser elements 101 and 102 are disposed so as to form an external resonator together with optical lenses 91 and 92, diffraction grating 95, and partially reflective mirror 97.

On the other hand, another portion of the laser beams traveling from diffraction grating 95 to partially reflective mirror 97 passes through partially reflective mirror 97 and is output as output light of semiconductor laser device 90. The output light is output as high-output laser beam to the outside of semiconductor laser device 90 via, for example, an optical fiber disposed on the optical axis of the output light.

Examples of the method for combining laser beams include wavelength beam combining to be used in semiconductor laser device 90 illustrated in Fig. 3 and spatial beam combining for spatially combining laser beams. In order to achieve narrower beams of combined light, the wavelength beam combining for converging laser beams having different wavelengths on the same optical axis is more advantageous than the spatial beam combining.

Optical path lengths of laser beams emitted from semiconductor laser element 101 and having wavelengths λ11 to λ1N from emission-side end face 50F to diffraction grating 95 and incidence angles of the laser beams with respect to diffraction grating 95 are different from each other. Similarly, optical path lengths of laser beams emitted from semiconductor laser element 102 and having wavelengths λ21 to λ2N from emission-side end face 50F to diffraction grating 95 and incidence angles of the laser beams with respect to diffraction grating 95 are different from each other. Therefore, by diffracting the laser beams having different wavelengths λ11 to λ1N and λ21 to λ2N by diffraction grating 95, the wavelengths of the laser beams change.

In the present exemplary embodiment, semiconductor laser device 90 includes two semiconductor laser elements 101 and 102, but semiconductor laser device 90 may include three or more semiconductor laser elements. As the number of semiconductor laser elements included in semiconductor laser device 90 increases, the light output value of semiconductor laser device 90 can be increased.

In addition, in order to further increase a light output, a plurality of semiconductor laser devices 90 that perform wavelength beam combining may be used, and beams output from semiconductor laser devices 90 may be combined by spatial beam combining.

As described above, semiconductor laser element 100 according to the first exemplary embodiment includes semiconductor stack body 50 that emits a laser beam, emission-side protective layer 1F disposed on emission-side end face 50F of semiconductor stack body 50, and non-emission-side protective layer 1R that is disposed on the end face (non-emission-side end face 50R) opposite to emission-side end face 50F of semiconductor stack body 50 and that reflects the laser beam.

Emission-side protective layer 1F includes control layer 22 that suppresses the reflectivity on the emission side with respect to the wavelength of the laser beam to be less than or equal to a predetermined value, and control layer 22 includes strain relaxation layer 30 that suppresses strain associated with the thermal expansion of control layer 22.

Thus, the reflectivity on the emission side of semiconductor stack body 50 can be maintained to be less than or equal to a predetermined value. In addition, the thermal expansion of emission-side protective layer 1F can be suppressed and the tensile stress generated at the interface between emission-side end face 50F of semiconductor stack body 50 and emission-side protective layer 1F can be reduced, whereby deterioration of emission-side end face 50F and separation of emission-side protective layer 1F can be prevented.

Therefore, the reflectivity on the emission side of semiconductor laser element 100 can be reduced, and the laser quality can be improved.

Further, semiconductor stack body 50 has a plurality of light emission points which is located on emission-side end face 50F and from which a plurality of laser beams is emitted. Further, the reflectivity on the emission side with respect to the wavelengths of the laser beams is less than or equal to a predetermined value.

That is, semiconductor laser element 100 can emit a plurality of laser beams and output high-quality laser beams. When semiconductor laser element 100 is mounted on external cavity semiconductor laser device 90 that performs wavelength beam combining, a semiconductor laser device that outputs high-quality laser beams can be achieved.

Further, when semiconductor laser element 100 is used in external cavity semiconductor laser device 90 that performs wavelength beam combining, an external resonator is formed between partially reflective mirror 97 and the non-emission-side end face of the semiconductor laser element. That is, a plurality of laser beams having different wavelengths is transmitted through emission-side protective layer 1F. However, according to the present exemplary embodiment, the reflectivity on the emission side with respect to a plurality of laser beams having different wavelengths can be suppressed to be less than or equal to a predetermined value without changing the layer structure of emission-side protective layer 1F for each light emission point. In addition, in a case where a plurality of laser beams from a plurality of semiconductor laser elements 100 is subjected to wavelength beam combining, the reflectivity on the emission side with respect to the wavelength of each of the laser beams can be suppressed to be less than or equal to a predetermined value only by disposing same emission-side protective layer 1F in each semiconductor laser element 100. Therefore, the configuration and manufacturing processes of semiconductor laser device 90 can be simplified. That is, manufacturing errors of the semiconductor laser device can be reduced to stabilize the manufacturing processes, and the cost can be reduced.

In the present exemplary embodiment, the reflectivity on the emission side with respect to the wavelengths of the laser beams emitted from semiconductor laser element 100 is suppressed to be less than or equal to 1.0%.

In addition, in the present exemplary embodiment, strain relaxation layer 30 is disposed at an intermediate position of control layer 22 in the traveling direction of laser beams.

Thus, both surfaces of strain relaxation layer 30 are in contact with main control layers 22a, whereby it is possible to further suppress the strain associated with the thermal expansion of control layer 22.

Emission-side protective layer 1F further includes barrier layer 21 disposed between emission-side end face 50F and control layer 22.

In a case where semiconductor laser element 100 is a gallium nitride semiconductor laser element, emission-side protective layer 1F and attendance-side end face 50F are likely to deteriorate due to diffusion of oxygen from the outside of emission-side protective layer 1F to semiconductor stack body 50. However, due to barrier layer 21 being disposed on emission-side protective layer 1F, diffusion of oxygen from the outside of emission-side protective layer 1F to semiconductor stack body 50 can be reduced. Therefore, deterioration of emission-side protective layer 1F and attendance-side end face 50F can be suppressed. Thus, the reliability of the output of semiconductor laser element 100 can be enhanced, and the operating period can be extended.

As described above, when semiconductor laser element 100 is a gallium nitride semiconductor laser element, emission-side protective layer 1F tends to be thick. As a result, as emission-side protective layer 1F becomes thicker, the tensile stress generated at the interface between emission-side protective layer 1F and emission-side end face 50F increases when emission-side protective layer 1F thermally expands. Therefore, emission-side end face 50F is easily deteriorated.

Emission-side protective layer 1F in the present exemplary embodiment has barrier layer 21 and is relatively thick as a whole. However, emission-side protective layer 1F has control layer 22 including strain relaxation layer 30. Therefore, in an element that emits high energy laser beams such as a gallium nitride semiconductor laser element, it is possible to output high-energy laser beams while suppressing the reflectivity on the emission side to be low, and to improve the quality of laser beams.

In addition, an oxynitride layer or a nitride layer having crystallinity similar to that of semiconductor stack body 50 may be used as barrier layer 21, by which an effect of protecting emission-side end face 50F can be enhanced.

The thickness of strain relaxation layer 30 is less than or equal to 2 nm.

Strain relaxation layer 30 is thin. Therefore, even if control layer 22 includes strain relaxation layer 30, the value of the reflectivity and the wavelength characteristics on the emission side with respect to the wavelengths of the plurality of laser beams are not changed as compared with an emission-side protective layer not including strain relaxation layer 30.

Strain relaxation layer 30 has the smallest thermal expansion coefficient among the layers included in emission-side protective layer 1F.

Specifically, strain relaxation layer 30 includes SiO₂.

As shown in Table 1, SiO₂ has a particularly small thermal expansion coefficient (about 0.5), and thus, it is possible to further suppress deterioration of emission-side end face 50F. In addition, SiO₂ has small light absorption in a wavelength band of laser beams emitted from the gallium nitride semiconductor laser element. Therefore, absorption of laser beams by strain relaxation layer 30 can be suppressed.

### (Second exemplary embodiment)

The second exemplary embodiment will be described below, focusing on differences from the first exemplary embodiment.

### [2-1. Overall configuration]

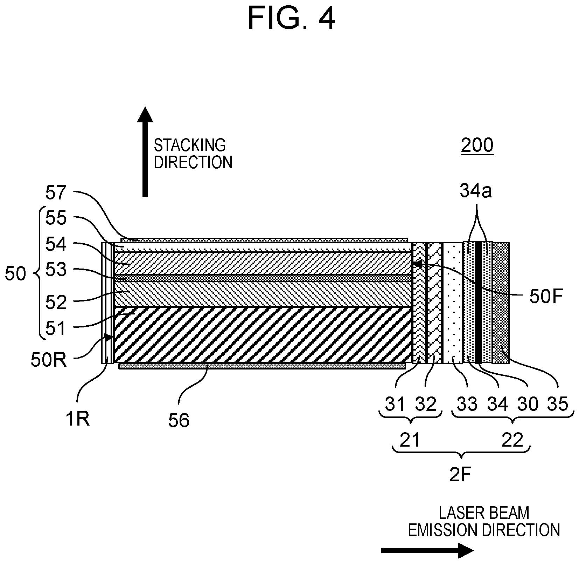

Fig. 4 is a schematic cross-sectional view illustrating semiconductor laser element 200 according to the second exemplary embodiment. Fig. 4 illustrates a cross section of semiconductor laser element 200 in a plane along a stacking direction of layers of semiconductor stack body 50 included in semiconductor laser element 200 and an emission direction of a laser beam.

Semiconductor laser element 200 is a semiconductor light emitting element that emits a plurality of laser beams. Similar to the first exemplary embodiment, semiconductor laser element 200 is a gallium nitride semiconductor laser element. Semiconductor laser element 200 includes semiconductor stack body 50, emission-side protective layer 2F, and non-emission-side protective layer 1R. Note that semiconductor laser element 200 differs from semiconductor laser element 100 according to the first exemplary embodiment only in the structure and function of emission-side protective layer 2F, and the other structures and functions are the same.

### [2-1-1. Emission-side protective layer]

Emission-side protective layer 2F includes barrier layer 21 and control layer 22.

### <Barrier layer>

Barrier layer 21 in the first exemplary embodiment has a one-layer structure, but barrier layer 21 in the present exemplary embodiment has a two-layer structure including first layer 31 and second layer 32.

First layer 31 is in contact with emission-side end face 50F of semiconductor stack body 50. First layer 31 is a dielectric layer, and is specifically an oxynitride layer or a nitride layer. A material of first layer 31 is the same as the material of barrier layer 21 in the first exemplary embodiment.

In the present exemplary embodiment, first layer 31 includes, for example, AlO₁₋ₓNₓ (0 < x < 1). The thickness of first layer 31 is, for example, about 20 nm. Note that first layer 31 may be, for example, an oxynitride layer such as a SiO₁₋ₓNₓ (0 < x < 1) layer, or a nitride layer such as an AlN layer or a SiN layer.

Second layer 32 is disposed in contact with the emission-side surface of first layer 31. Second layer 32 has a function of enhancing an effect of protecting emission-side end face 50F. Second layer 32 is a dielectric layer, and is specifically an oxynitride layer, a nitride layer, or an oxide layer.

In the present exemplary embodiment, second layer 32 includes, for example, Al₂O₃. The thickness of second layer 32 is, for example, about 10 nm. Note that second layer 32 may be, for example, an oxynitride layer such as a SiO₁₋ₓNₓ (0 < x < 1) layer or an AlO₁₋ₓNₓ (0 < x < 1) layer, a nitride layer such as a SiN layer or an AlN layer, or an oxide layer such as a SiO₂ layer.

Control layer 22 is farther from emission-side end face 50F than barrier layer 21, and is disposed in contact with the emission-side surface of barrier layer 21. Control layer 22 includes inner layer 33, intermediate layer 34, and outer layer 35. These layers are each a dielectric layer and are disposed in the order of inner layer 33, intermediate layer 34, and outer layer 35 from the side closer to barrier layer 21.

Due to control layer 22 including three types of layers, that is, inner layer 33, intermediate layer 34, and outer layer 35, it is possible to suppress the reflectivity on the emission side to be less than or equal to 1% for a wider range of wavelengths as compared with the first exemplary embodiment.

In the present exemplary embodiment, inner layer 33 includes, for example, Al₂O₃. The thickness of inner layer 33 is, for example, about 100 nm. Outer layer 35 includes, for example, SiO₂. The thickness of outer layer 35 is, for example, about 100 nm.

Intermediate layer 34 includes main intermediate layer 34a that contributes to adjustment of reflectivity and strain relaxation layer 30 that relaxes strain of entire control layer 22. Main intermediate layer 34a and strain relaxation layer 30 are different in material. In the present exemplary embodiment, main intermediate layer 34a includes, for example, ZrO₂.

Note that main intermediate layer 34a is only required to include a material having a greater refractive index with respect to laser beams than the refractive indexes of inner layer 33 and outer layer 35. Main intermediate layer 34a may be an oxynitride layer such as an AlO₁₋ₓNₓ (0 < x < 1) layer or a SiO₁₋ₓNₓ (0 < x < 1) layer, a nitride layer such as a SiN layer or an AlN layer, or an oxide layer such as a TiO₂ layer, a Nb₂O₅ layer, a Ta₂O₅ layer, or a HfO₂ layer. As will be described later, inner layer 33 may be a layer other than the Al₂O₃ layer. When inner layer 33 is a layer other than the Al₂O₃ layer, main intermediate layer 34a may be an Al₂O₃ layer.

In other words, it is only sufficient that inner layer 33 and outer layer 35 include materials whose refractive indexes with respect to each laser beam are smaller than the refractive index of main intermediate layer 34a. Inner layer 33 may be, for example, an oxynitride layer such as an AlO₁₋ₓNₓ (0 < x < 1) layer or a SiO₁₋ₓNₓ (0 < x < 1) layer, or an oxide layer such as a SiO₂ layer. Outer layer 35 may be, for example, an oxynitride layer such as an AlO₁₋ₓNₓ (0 < x < 1) layer or a SiO₁₋ₓNₓ (0 < x < 1) layer, or an oxide layer such as an Al₂O₃ layer.

Strain relaxation layer 30 is disposed so as to be located at an intermediate position of intermediate layer 34 in the traveling direction of laser beams. That is, strain relaxation layer 30 is sandwiched between two main intermediate layers 34a. Two main intermediate layers 34a may include the same material or different materials. Further, strain relaxation layer 30 includes SiO₂ and has a thickness of about 2 nm as in the first exemplary embodiment. On the other hand, the total thickness of main intermediate layers 34a on both sides of strain relaxation layer 30 is, for example, about 50 nm.

It is only sufficient that strain relaxation layer 30 includes a material having a thermal expansion coefficient smaller than that of at least main intermediate layer 34a. It is more desirable that strain relaxation layer 30 includes a material having the smallest thermal expansion coefficient among the layers included in emission-side protective layer 2F. In addition, strain relaxation layer 30 may be an oxynitride layer such as an AlO₁₋ₓNₓ (0 < x < 1) layer or a SiO₁₋ₓNₓ (0 < x < 1) layer, a nitride layer such as an AlN layer or a SiN layer, or an oxide layer such as an Al₂O₃ layer, a Ta₂O₅ layer, or a HfO₂ layer depending on the materials of the layers other than strain relaxation layer 30 in emission-side protective layer 2F.

In the second exemplary embodiment, since control layer 22 includes strain relaxation layer 30, effects similar to those of the first exemplary embodiment can be obtained. This will be described in detail below.

That is, since control layer 22 includes strain relaxation layer 30 including a material having a small thermal expansion coefficient, it is possible to reduce the tensile stress generated at the interface between emission-side protective layer 2F and emission-side end face 50F. Therefore, the reflectivity on the emission side of semiconductor laser element 200 can be reduced, and the laser quality can be improved.

In the second exemplary embodiment, strain relaxation layer 30 is disposed at an intermediate position of intermediate layer 34 in the traveling direction of laser beams. Therefore, strain associated with thermal expansion of entire emission-side protective layer 2F can be further reduced, and deterioration of emission-side protective layer 2F can be further suppressed.

It is only sufficient that the thickness of strain relaxation layer 30 is less than or equal to 2 nm.

As in the first exemplary embodiment, by reducing the thickness of strain relaxation layer 30, semiconductor laser element 200 has wavelength characteristics with respect to laser beams equivalent to those of a semiconductor laser element that does not have strain relaxation layer 30 and that has an emission-side protective layer having the same structure except for not having strain relaxation layer 30.

Control layer 22 in the present exemplary embodiment includes inner layer 33, main intermediate layer 34a, and outer layer 35, and inner layer 33, main intermediate layer 34a, and outer layer 35 are configured to suppress the reflectivity on the emission side to be less than or equal to 1.0% with respect to the oscillation wavelength of each laser beam when the emission-side protective layer without strain relaxation layer 30 is disposed on emission-side end face 50F. Therefore, the reflectivity on the emission side with respect to laser beams can be suppressed to be less than or equal to 1.0%. In addition, as compared with the first exemplary embodiment, the reflectivity on the emission side can be suppressed to be less than or equal to 1.0% with respect to a wider wavelength range.

Specifically, since semiconductor laser element 200 according to the second exemplary embodiment has emission-side end face 50F, the reflectivity on the emission side can be suppressed to be less than or equal to 1% with respect to a wavelength included in the wavelength range with a wavelength width more than or equal to 50 nm.

Note that the reflectivity on the emission side can be appropriately changed by changing the structure of the layers such as the material and thickness of each layer of emission-side protective layer 2F.

In addition, as in the first exemplary embodiment, the reflectivity on the emission side and the wavelength characteristics thereof are substantially the same wherever strain relaxation layer 30 is provided in control layer 22. That is, strain relaxation layer 30 may be disposed at any position in control layer 22, and for example, inner layer 33 or outer layer 35 may include strain relaxation layer 30.

Barrier layer 21 in the second exemplary embodiment has a two-layer structure, but may have a layer structure including three or more layers. In this case, at least a layer in contact with emission-side end face 50F may be a layer corresponding to first layer 31, that is, an oxynitride layer or a nitride layer. The two or more layers other than the layer in contact with emission-side end face 50F may not necessarily be an oxynitride layer such as an AlO₁₋ₓNₓ (0 < x < 1) layer or a SiO₁₋ₓNₓ (0 < x < 1) layer, or a nitride layer such as an AlN layer or a SiN layer, and may be an oxide layer such as an Al₂O₃ layer or a SiO₂ layer. In addition, first layer 31 may have a multilayer structure including at least one of an oxynitride layer and a nitride layer.

As described above, according to the second exemplary embodiment, semiconductor laser element 200 is a gallium nitride semiconductor laser element, and barrier layer 21 includes first layer 31 that is an oxynitride layer or a nitride layer.

Due to first layer 31 being disposed on emission-side end face 50F, diffusion of oxygen from the outside of emission-side protective layer 2F to semiconductor stack body 50 can be reduced. Thus, the deterioration of emission-side protective layer 2F can be prevented, whereby the reliability of the output of semiconductor laser element 100 can be enhanced, and the operating period can be extended.

The layer (first layer 31) in contact with emission-side end face 50F is an oxynitride layer or a nitride layer having crystallinity similar to that of semiconductor stack body 50. Accordingly, an effect of protecting emission-side end face 50F can be enhanced.

Barrier layer 21 includes, in addition to first layer 31, second layer 32 that is an oxynitride layer, a nitride layer, or an oxide layer.

Therefore, diffusion of oxygen from the outside of emission-side protective layer 2F to semiconductor stack body 50 can be further reduced. That is, the deterioration of emission-side end face 50F can be further suppressed, whereby the quality of laser beams from semiconductor laser element 100 can be further improved, and the operating period can be extended.

Control layer 22 includes inner layer 33, intermediate layer 34, and outer layer 35, and inner layer 33, intermediate layer 34, and outer layer 35 are disposed in the order of inner layer 33, intermediate layer 34, and outer layer 35 with respect to barrier layer 21. Intermediate layer 34 has strain relaxation layer 30, and main intermediate layer 34a of intermediate layer 34 includes a material different from those of inner layer 33 and outer layer 35.

The refractive index of main intermediate layer 34a with respect to laser beams is larger than the refractive indexes of inner layer 33 and outer layer 35 with respect to laser beams.

Therefore, as compared with the first exemplary embodiment, it is possible to suppress the reflectivity on the emission side to be less than or equal to 1% with respect to a wider wavelength range.

Inner layer 33 and outer layer 35 each include any of AlO₁₋ₓNₓ (0 < x < 1), SiO₁₋ₓNₓ (0 < x < 1), SiO₂, and Al₂O₃. Therefore, inner layer 33 and outer layer 35 can have a relatively low refractive index.

Main intermediate layer 34a includes AlO₁₋ₓNₓ (0 < x < 1), SiO₁₋ₓNₓ (0 < x < 1), AlN, SiN, Al₂O₃, ZrO₂, TiO₂, Nb₂O₅, Ta₂O₅, or HfO₂. Therefore, main intermediate layer 34a can have a relatively high refractive index.

### (Modifications)

Each of emission-side protective layers 1F and 2F may have any layer structure as long as it has control layer 22 including strain relaxation layer 30 and can suppress the reflectivity on the emission side of the semiconductor laser element to be less than or equal to a predetermined value. As long as emission-side protective layers 1F and 2F include at least one or more of an oxynitride layer, a nitride layer, or an oxide layer in addition to strain relaxation layer 30, the reflectivity on the emission side can be suppressed to be less than or equal to a predetermined value and the laser quality can be improved regardless of the layer structure.

Non-emission-side protective layer 1R may have any layer structure as long as the reflectivity more than or equal to a certain value on the non-emission side can be ensured. As long as non-emission-side protective layer 1R has at least one or more of an oxynitride layer, a nitride layer, or an oxide layer, the effects according to the first and second exemplary embodiments are not reduced regardless of the layer structure.

In the first and second exemplary embodiments, semiconductor laser element 100 has a plurality of light emission points, but a similar effect can be obtained even in a case where the semiconductor laser element has a single light emission point. That is, it is possible to suppress the reflectivity on the emission side with respect to the wavelength of the laser beam emitted from semiconductor laser element 100 to be less than or equal to a predetermined value, and to improve the laser quality and the output.

The semiconductor laser element may not be a gallium nitride semiconductor laser element. For example, the semiconductor laser element may be an AlGaInP semiconductor laser element, a gallium arsenide semiconductor laser element, or an InP semiconductor laser element. When the semiconductor laser element is an AlGaInP semiconductor laser element, the wavelength of an emitted laser beam is in a red wavelength band (a band from 600 nm to 700 nm inclusive). When the semiconductor laser element is a gallium arsenide semiconductor laser element, the wavelength of an emitted laser beam is in an infrared wavelength band (a band from 750 nm to 1100 nm inclusive). When the semiconductor laser element is an InP semiconductor laser element, the wavelength of an emitted laser beam is in a 1 µm band.

Note that semiconductor laser element 100 does not necessarily have barrier layer 21. For example, when the semiconductor laser element is an AlGaInP semiconductor laser element, a gallium arsenide semiconductor laser element, or an InP semiconductor laser element, deterioration of emission-side end face 50F due to diffusion of oxygen from the outside of emission-side protective layers 1F and 2F to semiconductor stack body 50 hardly occurs.

### (Example 1)

Catastrophic optical damage (COD) levels were examined for both a semiconductor laser element (hereinafter referred to as "Example 1") having strain relaxation layer 30 and a semiconductor laser element (hereinafter referred to as "Comparative Example") not having strain relaxation layer 30. The following conditions (1) to (2) are common in Example 1 and Comparative Example.
(1) When the wavelength of a laser beam emitted from the semiconductor laser element is λ, the thickness of the entire emission-side protective layer is about λ/2.
(2) The thickness of control layer 22 (the thickness of main control layer 22a in Example 1) is about 3λ/8.

Specifically, a reliability test was performed on the semiconductor laser elements according to Example 1 and Comparative Example, and COD levels were evaluated on the basis of a change in the light output value before and after the reliability test. As the reliability test performed by the present inventor, the semiconductor laser elements according to Example and Comparative Example continuously output laser beams for a long time (here, 1000 hours). Table 2 below shows the measurement results of the light output values of both elements.

**[Table 2]**

| Semiconductor element | Light output (mW) before reliability test | Light output (mW) after reliability test |
|---|---|---|
| Comparative Example | 1500 mW | 600 mW |
| Example 1 | 1500 mW | 850 mW |

In the semiconductor laser element according to Comparative Example, the light output value significantly decreased after the reliability test. That is, the COD level significantly decreased.

On the other hand, in the semiconductor laser element according to Example 1, an amount of decrease of the light output value after the reliability test from the light output value before the reliability test was smaller. That is, it can be said that a decrease in the COD level can be suppressed.

From the above results, the following has been found.
(I) The introduction of strain relaxation layer 30 into control layer 22 can reduce the tensile stress generated at the interface between semiconductor stack body 50 and the emission-side protective layer and suppress the deterioration of emission-side end face 50F.
(II) The measurement result of the semiconductor laser element according to Comparative Example suggests that, when an emission-side protective layer including relatively a thick layer having an optical layer thickness greater than or equal to 3λ/8 is disposed, tensile stress generated at an interface between the emission-side protective layer and emission-side end face 50F is increased, and deterioration of emission-side end face 50F proceeds.
(III) In particular, in a case where the emission-side protective layer is relatively thick, the insertion of strain relaxation layer 30 having a small thermal expansion coefficient into control layer 22 can decrease the tensile stress generated at the interface between the emission-side protective layer and emission-side end face 50F and suppress the deterioration of emission-side end face 50F.

Regarding semiconductor laser element 100 according to the first exemplary embodiment, control layer 22 includes strain relaxation layer 30 including a material having a thermal expansion coefficient smaller than that of the material of main control layer 22a, from the results of Example 1 and Comparative Example. Therefore, it can be said that, similar to the semiconductor laser element according to Example 1, the tensile stress generated at the interface between emission-side protective layer 1F and emission-side end face 50F can be reduced, and the deterioration of emission-side end face 50F can be suppressed. Thus, it can be said that the reflectivity on the emission side of semiconductor laser element 100 can be reduced, and the laser quality can be improved.

Regarding semiconductor laser element 200 according to the second exemplary embodiment, intermediate layer 34 of control layer 22 includes strain relaxation layer 30 including a material having a thermal expansion coefficient smaller than that of the material of main intermediate layer 34a. Therefore, it can be said that the same effects as those of the first exemplary embodiment can be obtained. Thus, it can be said that the reflectivity on the emission side of semiconductor laser element 200 can be reduced, and the laser quality can be improved.

### (Example 2)

The inventor examined an appropriate value of the thickness of strain relaxation layer 30. This appropriate value is the thickness of strain relaxation layer 30 required to obtain, as the reflectivity on the emission side, the reflectivity equivalent to that when the semiconductor laser element has an emission-side protective layer that does not include strain relaxation layer 30.

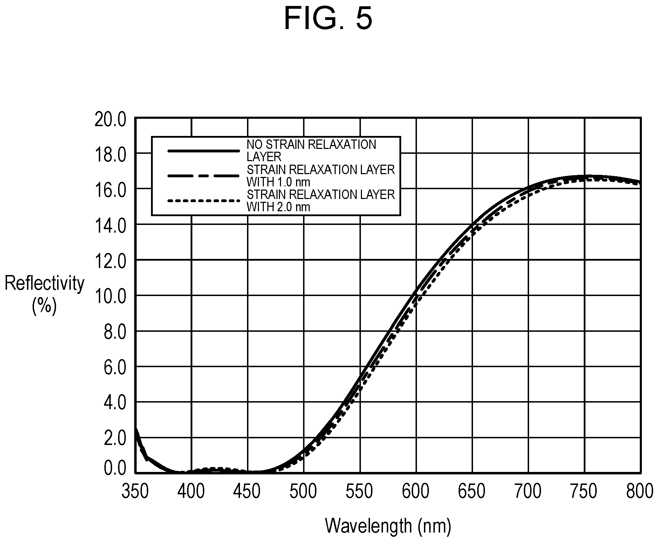

Fig. 5 is a graph illustrating reflectivity of the semiconductor laser element on the emission side according to the second exemplary embodiment. A solid line in Fig. 5 indicates reflectivity-wavelength characteristics of a semiconductor laser element having no strain relaxation layer, a dash-dot line indicates reflectivity-wavelength characteristics of a semiconductor laser element having strain relaxation layer 30 with a thickness of 1 nm, and a broken line indicates reflectivity-wavelength characteristics of a semiconductor laser element having strain relaxation layer 30 with a thickness of 2 nm. Note that the semiconductor laser elements according to Example 2 each include the control layer according to the second exemplary embodiment, that is, the control layer including the inner layer, the intermediate layer, and the outer layer. In addition, the intermediate layer of the semiconductor laser element having strain relaxation layer 30 has an SiO₂ layer as strain relaxation layer 30.

As shown in Fig. 5, when the thickness of the strain relaxation layer is less than or equal to 2.0 nm, reflectivity-wavelength characteristics equivalent to those of the semiconductor laser element not having strain relaxation layer 30 are exhibited. In addition, in a case where the thickness of the strain relaxation layer is less than or equal to 2.0 nm, a reflectivity less than or equal to 1.0% can be obtained in the 450 nm band including the oscillation wavelength of laser beam.

From the above results, it has been found that, when the thickness of strain relaxation layer 30 is less than or equal to 2.0 nm, reflectivity-wavelength characteristics equivalent to those of a semiconductor laser element not having strain relaxation layer 30 can be obtained. In addition, in a case where the reflectivity on the emission side is suppressed to be less than or equal to 1.0% at the oscillation wavelength of laser beam by the emission-side protective layer not having strain relaxation layer 30, it can be said that the reflectivity on the emission side is maintained to be less than or equal to 1.0% even if strain relaxation layer 30 is added to the emission-side protective layer.

In view of the above matters, since semiconductor laser element 100 according to the first exemplary embodiment includes strain relaxation layer 30 with a thickness less than or equal to 2.0 nm, it can be said that the reflectivity-wavelength characteristics on the emission side of semiconductor laser element 100 defined by main control layer 22a are not changed by adding strain relaxation layer 30.

Due to main control layer 22a being configured to suppress the reflectivity on the emission side to be less than or equal to 1.0% with respect to the oscillation wavelength of laser beam when the emission-side protective layer without strain relaxation layer 30 is disposed, the reflectivity on the emission side can be maintained to be less than or equal to 1.0% with respect to the oscillation wavelength of laser beam even if strain relaxation layer 30 is added to emission-side protective layer 1F.

Similarly, since semiconductor laser element 200 according to the second exemplary embodiment includes strain relaxation layer 30 with a thickness less than or equal to 2.0 nm, it can be said that the reflectivity-wavelength characteristics on the emission side of semiconductor laser element 200 defined by inner layer 33, main intermediate layer 34a, and outer layer 35 are not changed by adding strain relaxation layer 30.

Thus, it can be said that, due to inner layer 33, main intermediate layer 34a, and outer layer 35 being configured to suppress the reflectivity on the emission side to be less than or equal to 1.0% with respect to the oscillation wavelength of laser beam when the emission-side protective layer without strain relaxation layer 30 is disposed, the reflectivity on the emission side can be maintained to be less than or equal to 1.0% even if strain relaxation layer 30 is added to the emission-side protective layer.

In addition, semiconductor laser element 200 according to the second exemplary embodiment and the semiconductor laser element according to Example 2 are similar in structure to each other. That is, semiconductor laser element 200 according to the second exemplary embodiment includes control layer 22 that has inner layer 33, intermediate layer 34, and outer layer 35 as in the semiconductor laser element according to Example 2. Therefore, it can be said that, according to semiconductor laser element 200 in the second exemplary embodiment, the reflectivity-wavelength characteristics on the emission side are close to those shown in Fig. 5.

Specifically, it is presumed that, since semiconductor laser element 200 according to the second exemplary embodiment has emission-side protective layer 2F, the reflectivity on the emission side is suppressed to be less than or equal to 1% in the wavelength range with a wavelength width greater than or equal to 50 nm.

More specifically, according to the second exemplary embodiment, it is presumed that the reflectivity on the emission side is suppressed to be less than or equal to 1% in the wavelength range in which the center wavelength is about 420 nm and the wavelength width is about 130 nm, as illustrated in Fig. 5. Note that, in the second exemplary embodiment, the reflectivity on the emission side can be suppressed to be less than or equal to 1.0% with respect to a wider wavelength range as compared to the first exemplary embodiment.

### (Example 3)

The inventor has examined the reflectivity-wavelength characteristics on the emission side by changing the position of strain relaxation layer 30 in control layer 22, and has found that the wavelength characteristics and the reflectivity were substantially the same as those illustrated in Fig. 5. That is, in a case where the layers other than strain relaxation layer 30 included in emission-side protective layers 1F and 2F are formed so that the reflectivity on the emission side is less than or equal to 1% with respect to the oscillation wavelength of laser beam, it can be said that, wherever strain relaxation layer 30 is located in control layer 22, the reflectivity on the emission side is suppressed to be less than or equal to 1% with respect to the oscillation wavelength of laser beam. For example, in the second exemplary embodiment, the reflectivity on the emission side and the wavelength characteristics thereof are substantially the same even if inner layer 33 or outer layer 35 has strain relaxation layer 30.

The present disclosure also includes a mode obtained by making various modifications conceivable by those skilled in the art to each of the exemplary embodiments and modifications, and a mode obtained by combining any components and any functions in each of the exemplary embodiments without departing from the gist of the present disclosure.

The present disclosure can provide a semiconductor laser element capable of reducing reflectivity on the side of the laser-beam emission-side end face and improving laser quality.

### INDUSTRIAL APPLICABILITY

The present disclosure can be suitably applied to a semiconductor laser element having a protective layer that is disposed on the side of a laser-beam emission-side end face.

### REFERENCE MARKS IN THE DRAWINGS

1F emission-side protective layer
1R non-emission-side protective layer
11 first light emitter
12 second light emitter
14 emission-side protective layer
14A, 14B, 14C dielectric layer
21 barrier layer
22 control layer
22a main control layer
30 strain relaxation layer
31 first layer
32 second layer
33 inner layer
34 intermediate layer
34a main intermediate layer
35 outer layer
50 semiconductor stack body
50F laser-beam emission-side end face
50R laser-beam non-emission-side end face
51 substrate
52 first semiconductor layer
53 active layer
54 second semiconductor layer
55 contact layer
56 first electrode
57 second electrode
90 semiconductor laser device
91, 92 optical lens
95 diffraction grating
97 partially reflective mirror
100, 101, 102, 200 semiconductor laser element

## Claims

1. A semiconductor laser element comprising:
a semiconductor stack body that emits a laser beam;
an emission-side protective layer disposed on an emission end face of the semiconductor stack body, the emission end face being an end face from which the laser beam is emitted; and
a non-emission-side protective layer that is disposed on an end face of the semiconductor stack body on a side opposite to the emission end face and that reflects the laser beam,
wherein
the emission-side protective layer includes a control layer that suppresses a reflectivity on an emission side with respect to a wavelength of the laser beam to be less than or equal to a predetermined value, and
the control layer includes a strain relaxation layer that suppresses strain associated with thermal expansion of the control layer.

2. The semiconductor laser element according to Claim 1, wherein
the semiconductor stack body has a plurality of light emission points located on the emission end face, a plurality of the laser beams being emitted from the plurality of light emission points, and
the reflectivity is less than or equal to the predetermined value with respect to wavelengths of the plurality of laser beams.

3. The semiconductor laser element according to Claim 1 or 2, wherein
the strain relaxation layer is disposed at an intermediate position in the control layer in a traveling direction of the laser beam.

4. The semiconductor laser element according to any one of Claims 1 to 3, wherein
the emission-side protective layer further includes a barrier layer disposed between the emission end face and the control layer.

5. The semiconductor laser element according to Claim 4, the semiconductor laser element being a gallium nitride semiconductor laser element,
wherein the barrier layer includes a first layer that is an oxynitride layer or a nitride layer.

6. The semiconductor laser element according to Claim 5, wherein
the first layer includes AlO₁₋ₓNₓ (0 < x < 1), SiO₁₋ₓNₓ (0 < x < 1), AlN, or SiN.

7. The semiconductor laser element according to Claim 5 or 6, wherein
the barrier layer further includes a second layer that is an oxynitride layer, a nitride layer, or an oxide layer.

8. The semiconductor laser element according to Claim 7, wherein
the second layer includes SiO₁₋ₓNₓ (0 < x < 1), AlO₁₋ₓNₓ (0 < x < 1), SiN, AlN, Al₂O₃, or SiO₂.

9. The semiconductor laser element according to any one of Claims 4 to 8, wherein
the control layer includes an inner layer, an intermediate layer, and an outer layer,
the inner layer, the intermediate layer, and the outer layer are disposed in order of the inner layer, the intermediate layer, and the outer layer with respect to the barrier layer,
the intermediate layer includes the strain relaxation layer, and
the intermediate layer includes a layer other than the strain relaxation layer, the layer including a material different from materials of the inner layer and the outer layer.

10. The semiconductor laser element according to Claim 9, wherein
each of the inner layer and the outer layer includes AlO₁₋ₓNₓ (0 < x < 1), SiO₁₋ₓNₓ (0 < x < 1), SiO₂, or Al₂O₃.

11. The semiconductor laser element according to Claim 9 or 10, wherein
the layer of the intermediate layer other than the strain relaxation layer includes SiO₁₋ₓNₓ (0 < x < 1), AlO₁₋ₓNₓ (0 < x < 1), SiN, AlN, Al₂O₃, ZrO₂, TiO₂, Nb₂O₅, Ta₂O₅, or HfO₂.

12. The semiconductor laser element according to any one of Claims 9 to 11, wherein
the layer of the intermediate layer other than the strain relaxation layer has a refractive index larger than both a refractive index of the inner layer and a refractive index of the outer layer.

13. The semiconductor laser element according to any one of Claims 1 to 12, wherein
the strain relaxation layer has a thickness less than or equal to 2 nm.

14. The semiconductor laser element according to any one of Claims 1 to 13, wherein
the strain relaxation layer has a smallest thermal expansion coefficient among layers included in the emission-side protective layer.

15. The semiconductor laser element according to any one of Claims 1 to 14, wherein
the strain relaxation layer includes SiO₂.

16. The semiconductor laser element according to any one of Claims 1 to 15, wherein
the reflectivity with respect to the wavelength of the laser beam is less than or equal to 1.0%.

17. The semiconductor laser element according to Claim 1, wherein
the control layer further includes a first main control layer and a second main control layer, and the strain relaxation layer is located between the first main control layer and the second main control layer.
